(19) Europäisches Patentamt
European Patent Office
Office européen des brevets

(11) **EP 4 582 761 A1**

(12) **EUROPEAN PATENT APPLICATION**
published in accordance with Art. 153(4) EPC

(43) Date of publication:
**09.07.2025 Bulletin 2025/28**

(21) Application number: 23837123.1

(22) Date of filing: **31.10.2023**

(51) International Patent Classification (IPC):
***F28D 15/04*** *(2006.01)*

(52) Cooperative Patent Classification (CPC):
**F28D 15/02; F28D 15/04; H05K 7/20**

(86) International application number:
**PCT/CN2023/128021**

(87) International publication number:
**WO 2025/086314 (01.05.2025 Gazette 2025/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.10.2023 CN 202311387859**

(71) Applicant: **Shenzhen Fluentrop Technology Co.,
Ltd.
Shenzhen, Guangdong 518055 (CN)**

(72) Inventors:
• **ZHU, Yonggang
Shenzhen, Guangdong 518107 (CN)**
• **LU, Qiaorou
Shenzhen, Guangdong 518107 (CN)**

(74) Representative: **Wächter, Jochen
Kroher-Strobel
Rechts- und Patentanwälte PartmbB
Bavariaring 20
80336 München (DE)**

(54) **LIQUID ABSORBING WICK AND MANUFACTURING METHOD THEREFOR, AND VAPOR CHAMBER**

(57) A wick, a preparation method thereof, and a temperature equalization board are proposed. The wick is configured for being installed on a housing, and the housing includes cover plates. First diversion grooves and second diversion grooves are formed in both sides of the wick, respectively. The first diversion grooves are configured for forming first capillary channels together with the cover plates. The first capillary channels and the second diversion grooves are configured for connecting a heat source area with a heat dissipation area. Capillary through holes for working liquid and vapor of working liquid to pass through are formed in the first diversion groove. Vapor-liquid interfaces formed in the first capillary channel and the second diversion groove serve as phase-change interfaces to provide evaporation interfaces at a heat absorption end and condensation interfaces at a heat dissipation end, and capillary pressure is formed to drive the condensed working liquid to flow back to the heat source area. Compared with the prior art, the present technical solution can increase the capillary pressure and the back-flow velocity of the working liquid to the heat source area, so that the heat transfer capability of the temperature equalization board is improved. By adjusting the sizes of the capillary through hole and the first capillary channel, the characteristics of high capillary pressure and large flow rate can be both realized.

FIG. 24

## Description

### TECHNICAL FIELD

The present invention relates to the technical field of heat dissipation devices, in particular to a wick, a preparation method thereof, and a temperature equalization board.

### BACKGROUND

Temperature equalization board is a commonly used heat conducting element, which includes a housing, a wick and working liquid. A chamber is formed in the housing, and the wick and the working liquid are located in the chamber. When the temperature equalization board is in use, cover plates of the housing contact with a heat source, area directly facing the heat source on the temperature equalization board forms a heat source area, and a heat dissipation area is arranged outside the heat source area. The wick can be of a mesh structure, a sintered copper powder structure, a micro-column array structure, a groove structure, a foam metal structure and other structures. The wick has capillary performance and can adsorb working liquid.

During the operation of the temperature equalization board, the working liquid in the heat source area is heated and evaporated, and vapor overflows from the wick and flows into the vapor chamber of the housing. After leaving the heat source area, the vapor is condensed into liquid and releases heat. The liquid flows back to the heat source area under the action of the wick. The above evaporation heat absorption and condensation heat release processes are carried out cyclically, and some of the heat from the heat source area is transferred to the heat dissipation area, so that difference in temperature between the heat source area and the heat dissipation area is decreased, and the effect of temperature equalization is finally achieved.

In the prior art, the capillary pressure of the wick is limited or cannot be adjusted, so that working length and heat conduction efficiency of the temperature equalization board are limited. Especially, in the case of against acceleration, the capillary pressure is limited, so that the heat conduction efficiency is sharply decreased and the temperature equalization board even stops working. For example, when the working liquid flows on the wick of a currently widely used mesh structure and some foam structures, the capillary force comes from a capillary structure formed between wires or between the wires and the housing plate, and the capillary capacity is poor. Further, the flow path of the working liquid may be an irregular porous structure of the wick itself, with tortuous internal flow paths, many invalid paths may exist, these result in high flow resistance. Although some existing wicking materials such as tightly woven filament structures and fiber structures have high capillary forces,, these structures are low in porosity, high in flow resistance and consequently low in capillary flow rate. The wick of a groove structure or a similar groove structure has also been widely developed in recent years, mainly due to the machinability of this material. However, the groove structure has open channels with relatively poor capillarity, resulting in the disadvantages of small flow velocity and flow rate of the working liquid. The heat conduction capacity of the temperature equalization board is reduced. Therefore, the wick needs to have both advantages of high capillary force and large capillary flow rate, so that the circulation of the working liquid can be enhanced, and the heat conduction capacity of the temperature equalization board can be improved.

### SUMMARY

The purpose of the present invention is to provide a wick preparation method thereof, and a temperature equalization board, Therefore, backflow velocity of working liquid to a heat source area is increased so as to improve cooling capacity of the temperature equalization board.

In order to achieve the above purpose, the following solution is proposed in the present invention.

A wick installed inside a housing is proposed in the present invention. The housing includes cover plates. First diversion grooves are formed in the wick. The first diversion grooves are configured for forming first capillary channels together with the cover plates.

The first capillary channels are configured for connecting a heat source area and a heat dissipation area, so that working liquid condensed in the heat dissipation area is capable of flowing back to the heat source area through the first capillary channels under capillary pressure.

In some embodiments, the housing includes a vapor chamber, and the vapor chamber is located on a side, away from the cover plates, of the wick. Capillary through holes are formed in the wick, and the capillary through holes are configured for communicating the first diversion grooves with the vapor chamber, so that the working liquid and vapor of the working liquid are capable of flowing between the first diversion grooves and the vapor chamber.

In some embodiments, second diversion grooves are further formed in the wick, and the second diversion grooves are located on a side, adjacent to the vapor chamber, of the wick. The second diversion grooves are configured for connecting the heat source area with the heat dissipation area, so that the working liquid condensed in the heat dissipation area is capable of flowing back to the heat source area through the second capillary channels under capillary pressure.

In some embodiments, first ends of the first capillary channels are configured for being located in the heat source area, and second ends of the first capillary channels are configured for being located in the heat dissipation area. An effective capillary radius of the capillary through holes located at the first ends of the first capillary channels is smaller than that of the capillary through holes located at the second ends of the first capillary channels so as to increase the capillary pressure for the working liquid to flow back to the heat source area.

In some embodiments, connecting channels are further formed in the wick. A plurality of first capillary channels are provided, and every two adjacent first capillary channels are connected through the connecting channels, so that the working liquid and the vapor of the working liquid are capable of flowing between different first capillary channels.

In some embodiments, the connecting channels include connecting grooves, and the connecting grooves are configured for forming second capillary channels together with the cover plates.

The present invention also provides a temperature equalization board, including the above wick and a housing. The housing includes cover plates, sides of the cover plates are configured for being in contact with a heat source, and another sides of the cover plates are configured for forming the first capillary channels together with the first diversion grooves.

In some embodiments, the housing includes a vapor chamber, and the vapor chamber is located on a side, away from the cover plates, of the wick. Capillary through holes are formed in the wick, and the capillary through holes are configured for communicating the first diversion grooves with the vapor chamber, so that working liquid and vapor of the working liquid are capable of flowing between the first diversion grooves and the vapor chamber.

The present invention also provides a preparation method of a wick, for preparing the above wick, including:

arranging strip structures on a surface of a base to obtain a substrate, providing the surface, with the strip structures, of the substrate as a deposition surface;
depositing a metal layer on the deposition surface of the substrate to cover at least part of a deposited surface; the metal layer is made of material different from materials of both the strip structures and the base; and
removing the base and the strip structures for forming the first diversion grooves.

In some embodiments, the preparation method of a wick further including:
forming capillary through holes in the first diversion grooves.

Compared with the prior art, the present invention has the following technical effects.

The first diversion grooves of the wick are configured for forming first capillary channels together with the cover plates. The first capillary channels are each of a tubular structure with a specific direction. The cross-section of the tubular structure can be in a rectangular shape, a trapezoidal shape, a semicircular shape, a superior arc bow shape, an inferior arc bow shape or similar shapes. Compared with the prior art, such as a groove structure or open structure (including a mesh structure, a sintered copper powder structure and a foam structure), in the present invention, the working liquid flows along the first capillary channels rather than an internally blocked path in the process of flowing back to the heat source area from the heat dissipation area, so that the flow resistance of the working liquid is smaller, the flow path is shorter, the backflow velocity of the working liquid to the heat source area can be effectively increased, and the heat transfer capability of the heat equalization board is improved.

In preferred solutions of the present invention, capillary through holes are formed in the first capillary channels, so that capillary pressure is jointly provided by the vapor-liquid interfaces in the first capillary channels and the second diversion grooves, the difference in capillary pressure between the heat source area and the heat dissipation area is increased, the backflow velocity of the working liquid to the heat source area can be effectively increased, and thus the heat transfer capacity of the heat equalization board is improved. By adjusting the sizes of the capillary through holes and the first capillary channels, the characteristics of high capillary pressure and large flow rate can be both realized. The shortcomings of randomness and difficulty in adjusting the capillary pressure and flow rate of the working liquid in traditional solutions are solved.

In preferred solutions of the present invention, the effective capillary radius of the capillary through holes located at the heat source area is smaller than that of the capillary through holes located at the heat dissipation area so as to further increase the capillary pressure for the working liquid to flow back to the heat source area.

The temperature equalization board and the preparation method of the wick both have corresponding technical effects to the wick, and will not repeated here.

## BRIEF DESCRIPTION OF THE DRAWINGS

To more clearly illustrate technical solutions in embodiments of the present invention or in the prior art, the following briefly introduces the attached figures to be used in the embodiments. Apparently, the attached figures in the following description show merely some embodiments of the present invention, and those skilled in the art may still obtain other figures from these attached figures without creative efforts.

FIG. 1 is a schematic diagram of a wick connected to a cover plate according to an embodiment of the present invention;
FIG. 2 is another schematic diagram of a wick connected to a cover plate according to an embodiment of the present invention;
FIG. 3 is another schematic diagram of a wick connected to a cover plate according to an embodiment of the present invention;
FIG. 4 is another schematic diagram of a wick connected to a cover plate according to an embodiment of the present invention;
FIG. 5 is another schematic diagram of a wick connected to a cover plate according to an embodiment of the present invention;
FIG. 6 is another schematic diagram of a wick connected to a cover plate according to an embodiment of the present invention;
FIG. 7 is a top view of a wick according to an embodiment of the present invention;
FIG. 8 is a top view of a wick according to another embodiment of the present invention;
FIG. 9 is a top view of a wick according to another embodiment of the present invention;
FIG. 10 is a top view of a wick according to another embodiment of the present invention;
FIG. 11 is a top view of a wick according to another embodiment of the present invention;
FIG. 12 is a top view of a wick according to another embodiment of the present invention;
FIG. 13 is a top view of a wick according to another embodiment of the present invention;
FIG. 14 is a top view of a wick according to another embodiment of the present invention;
FIG. 15 is a schematic diagram of an arrangement of a wick according to an embodiment of the present invention;
FIG. 16 is a schematic diagram of an arrangement of a wick according to another embodiment of the present invention;
FIG. 17 is a cross-sectional diagram of an arrangement of a wick in a vapor chamber on one side of the housing according to an embodiment of the present invention;
FIG. 18 is a cross-sectional diagram of an arrangement of a wick in a vapor chamber on one side of the housing according to another embodiment of the present invention;
FIG. 19 is a cross-sectional schematic diagram of an arrangement of wicks in a vapor chamber on both sides of the housing according to an embodiment of the present invention;
FIG. 20 is a cross-sectional schematic diagram of a wick when working liquid is transported in first capillary channels according to an embodiment of the present invention;
FIG. 21 is a cross-sectional schematic diagram of a wick when working liquid is transported in first capillary channels and second diversion grooves simultaneously according to an embodiment of the present invention;
FIG. 22 is a cross-sectional schematic diagram of a wick when working liquid is transported in an evaporation area according to an embodiment of the present invention;
FIG. 23 is a cross-section schematic diagram of a wick when working liquid is transported in a condensation area according to an embodiment of the present invention;
FIG. 24 is an exploded schematic view of a temperature equalization board according to an embodiment of the present invention;
FIG. 25 is a schematic diagram of example 1 of a preparation method of a wick according to an embodiment of the present invention;
FIG. 26 is a schematic diagram of example 2 of a preparation method of a wick according to an embodiment of the present invention;
FIG. 27 is a schematic diagram of example 3 of a preparation method of a wick according to an embodiment of the present invention; and
FIG. 28 illustrates comparison between capillary performance test data of a wick according to an embodiment of the present invention and that of commercial mesh materials.

Reference signs: 100 temperature equalization board; 101 first cover plate; 102 second cover plate; 103 vapor chamber; 104 support; 199 deposition metal layer; 200 wick; 201 photosensitive film; 201a strip mold structure; 202 base; 210 first capillary channel; 220 second diversion groove; 230 connecting channel; 250 capillary through hole; 300 working liquid; 310 second vapor-liquid interface; 320 first vapor-liquid interface; 400 heat source area; 410 heat insulation area; and 420 heat dissipation area.

## DETAILED DESCRIPTION OF THE EMBODIMENTS

The following clearly and completely describes the technical solutions in the embodiments of the present invention with reference to attached figures of the embodiments of the present invention. Apparently, the described embodiments are merely a part rather than all of the embodiments of the present invention. Based on the embodiments in the present invention, all other embodiments obtained by those skilled in the art without creative efforts fall within the scope protected by the present invention.

The purpose of the present invention is to provide a wick, preparation method thereof, and temperature equalization board. The backflow velocity of working liquid to the heat source area is increased so as to improve the heat conduction capacity of the temperature equalization board.

To make the foregoing purpose, features and advantages of the present invention clearer and easier to understand, the present invention is further described in detail below with reference to the attached figures and specific embodiments.

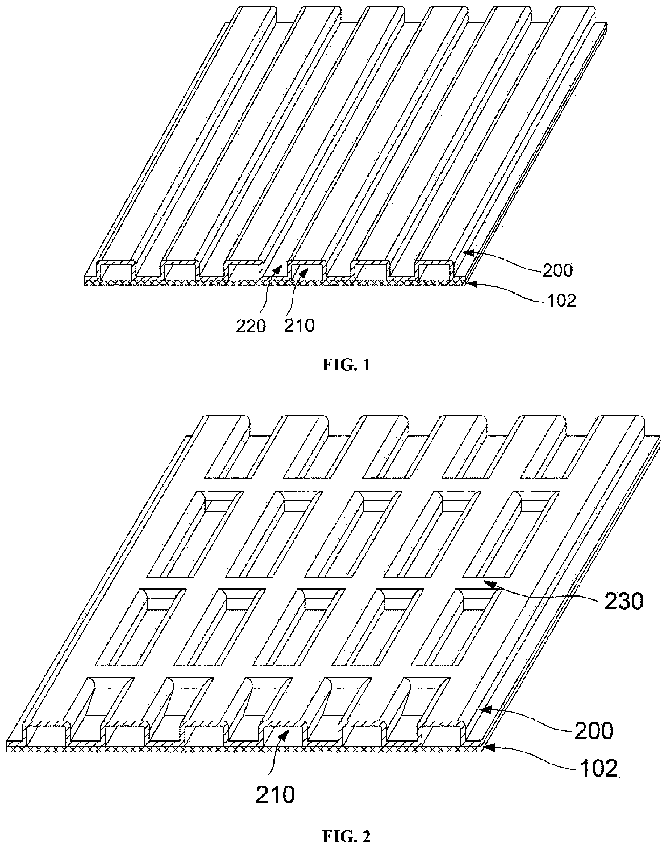

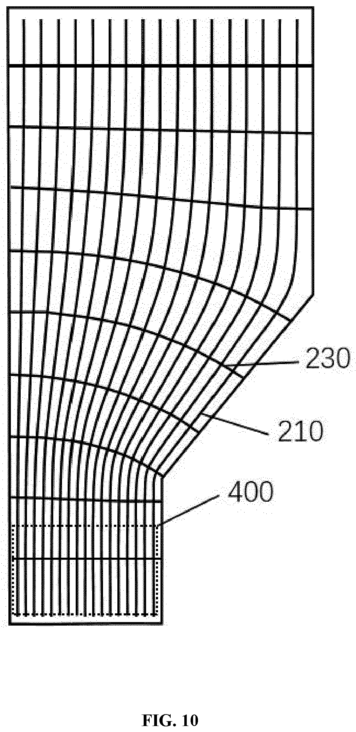

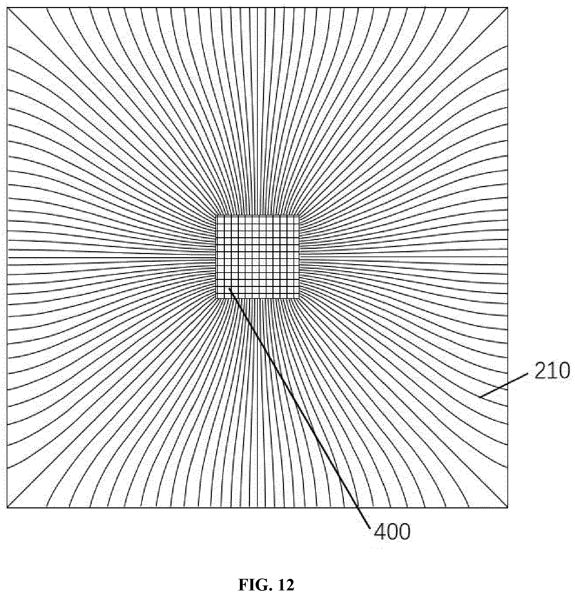

Referring to FIG. 1 to FIG. 23, the present embodiment provides a wick 200. The wick 200 is installed on a housing of a temperature equalization board 100, and the housing includes cover plates. First diversion grooves are formed in the wick 200. The first diversion grooves are configured for forming first capillary channels 210 together with the cover plates. The cover plates and the wick 200 can be fixedly connected by thermal bonding.

The first capillary channels 210 are configured for connecting a heat source area 400 (also called an evaporation area) with a heat dissipation area 420 (also called a condensation area), so that working liquid 300 condensed in the heat dissipation area 420 can flow back to the heat source area 400 through the first capillary channels 210 under capillary pressure.

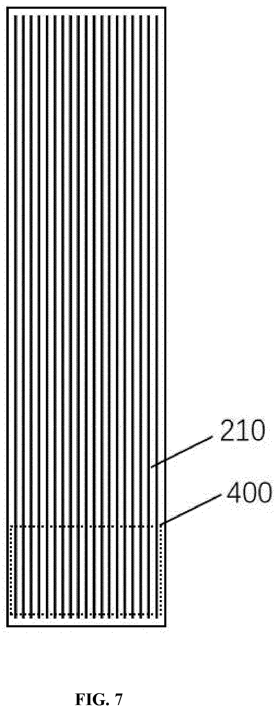

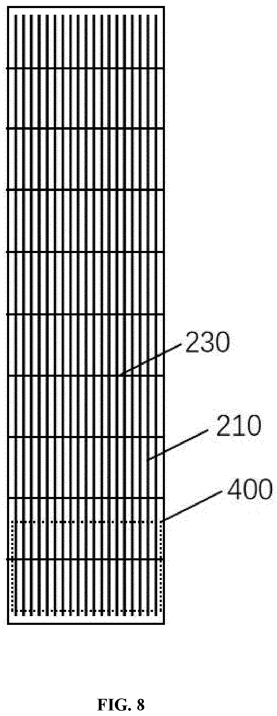

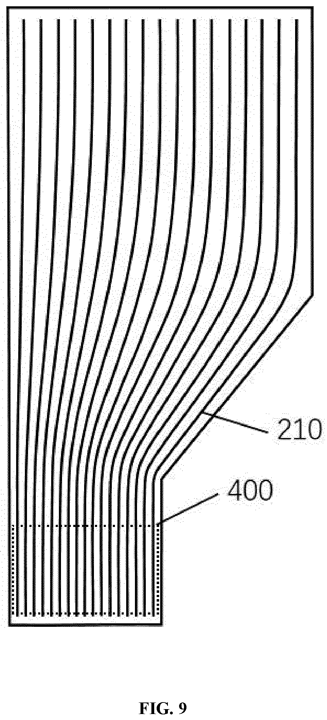

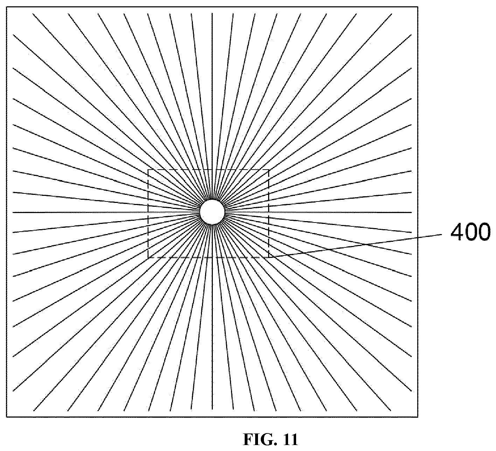

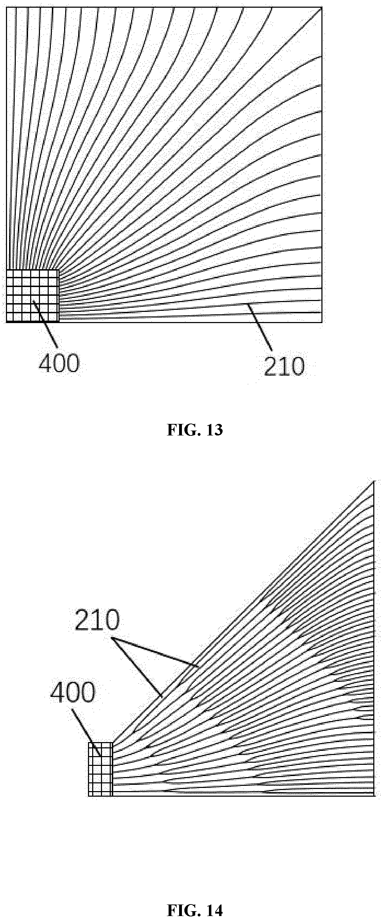

FIG. 7 to FIG. 14 provide top views of several examples of the wick 200 in the present embodiment. When a plurality of first diversion grooves are provided, the first diversion grooves can be in a linear shape, referring to FIG. 7, FIG. 8 and FIG. 11. In FIG. 7 and FIG. 8, the first diversion grooves are parallel to one another. The first diversion grooves can also be in a curved shape, referring to FIG. 9, FIG. 10, FIG. 12, FIG. 13 and FIG. 14. In FIG. 11, FIG. 12 and FIG. 13, the first diversion grooves are radially distributed. Referring to FIG. 14, the first diversion grooves can be designed in a bifurcation structure along a flow direction so as to increase contact area of a condensation section and collect the condensed working liquid 300 to flow back better. However, actual implementations are not limited to this. According to the designed heat conduction requirement of the temperature equalization board, the grid shape of the channels can be flexibly designed to realize the purpose of the present invention.

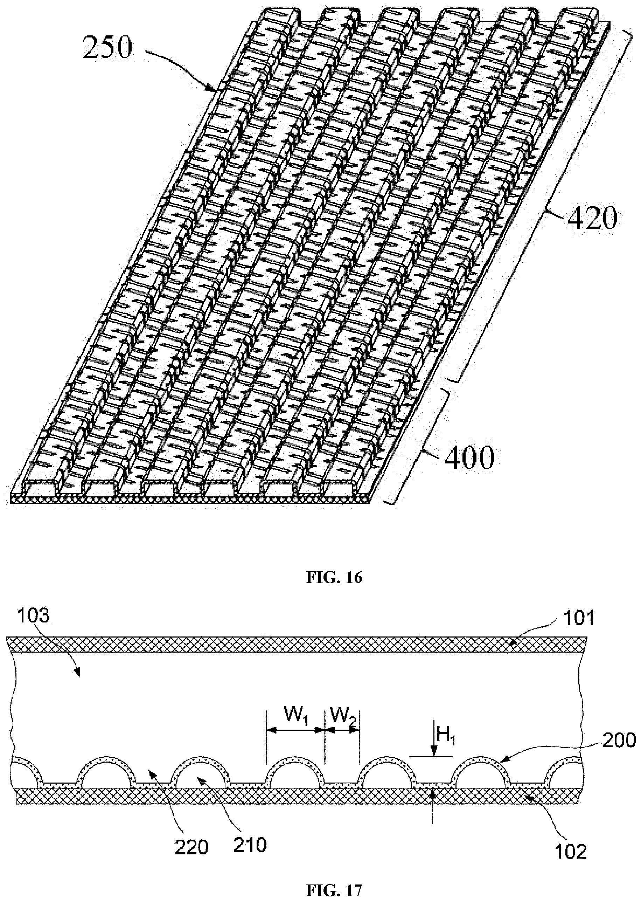

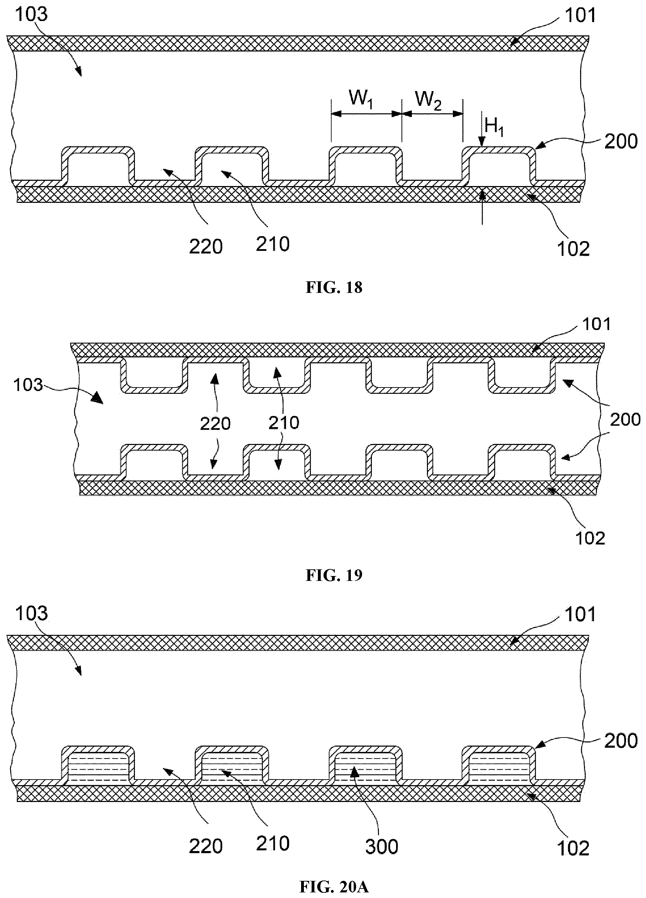

FIG. 17 to FIG. 19 provide the cross-sectional shapes of several examples of the wick 200 in the present invention. The cross section of the first diversion grooves can be in a semicircular shape (referring to FIG. 17), a square shape (referring to FIG. 18 and FIG. 19), an arcuate shape, a trapezoidal shape, a triangular shape, and other shapes, which can be selected by those skilled in the art according to actual needs.

In the examples corresponding to FIG. 18 and FIG. 19, the cross section of the first capillary channel 210 is in a rectangular shape, with a width of 10 microns to 2 millimeters and a height of 1 micron to 500 microns.

The working principle of the wick 200 in the embodiment is as follows.

The first diversion grooves of the wick 200 are configured for forming first capillary channels 210 together with the cover plates. The first capillary channels 210 are each of a tubular structure with a specific direction. Compared with the prior art, in the embodiment, the working liquid 300 flows along the first capillary channels 210 without any internal blockage during the process of flowing back to the heat source area 400 from the heat dissipation area 420, so that the flow resistance of the working liquid 300 is smaller, the flow path is shorter, the backflow velocity of the working liquid 300 to the heat source area 400 can be effectively increased, and the heat transfer capability of the heat equalization board is improved.

The housing of the temperature equalization board 100 is of a closed structure. The cover plates include a second cover plate 102 and a second cover plate 101 in opposite positions, and the second cover plate 102 and the second cover plate 101 are connected through several side plates. The wick 200 is located between the second cover plate 102 and the second cover plate 101. The wick 200 has two arrangement forms.

In a first arrangement form, a side of the wick 200 is connected with the second cover plate 102, and another side of the wick 200 is connected with the second cover plate 101. In such a case, the first capillary channels 210 are formed between the second cover plate 102 and the wick 200, as well as between the second cover plate 101 and the wick 200 (this form is not shown in the figures).

In a second arrangement form, a side of the wick 200 is connected with the second cover plate 102 or the second cover plate 101, and a vapor chamber 103 is formed on the other side of the wick 200 (referring to FIG. 17 to FIG. 24). The wicks 200 can be arranged on both the second cover plate 102 and the second cover plate 101 (referring to FIG. 19), or the wick 200 can be arranged on only one cover plate, either the second cover plate 102 or the second cover plate 101 (referring to FIG. 17, FIG. 18, and FIG. 20 to FIG. 24).

As a possible example, for the second arrangement form of the wick 200, capillary through holes 250 are formed in the wick 200 for communicating the first diversion grooves with the vapor chamber 103. Specifically, capillary through holes 250 are used for the working liquid 300 and vapor of the working liquid 300 to flow between the first diversion grooves and the vapor chamber 103. In the heat source area 400, the capillary through holes 250 provides an evaporation interface.

In the heat dissipation area 420, the capillary through holes 250 provide a condensation interface.

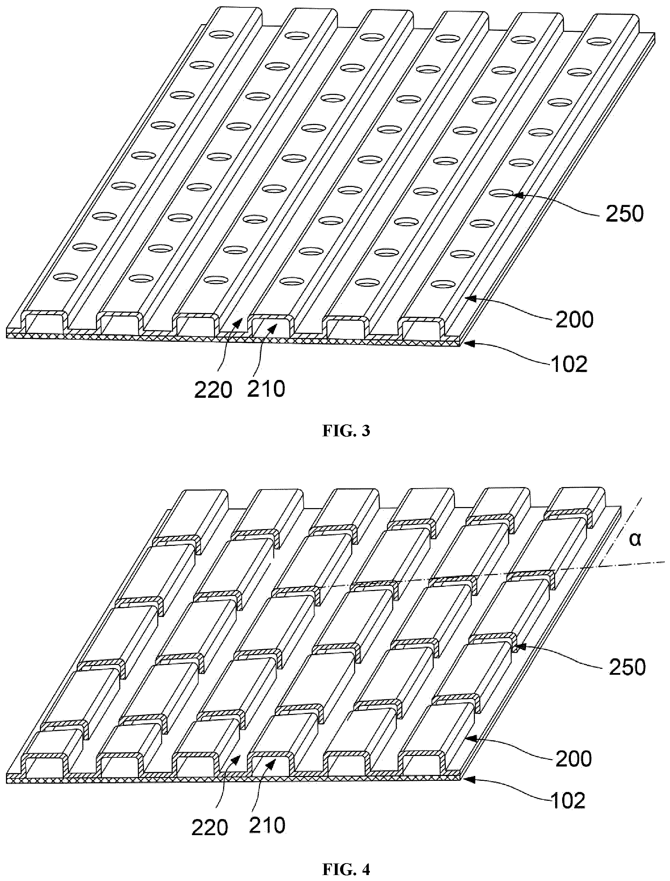

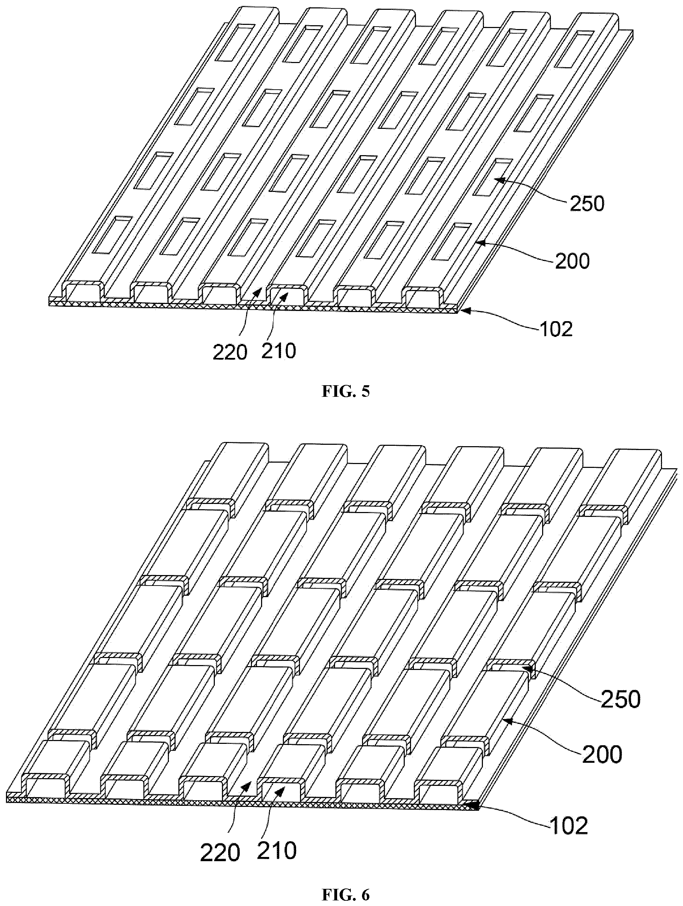

The shapes and arrangement formats of the capillary through holes 250 can be flexibly selected and are only illustrated as examples below. When the size of the capillary through holes 250 is large, the capillary through holes can span multiple first diversion grooves (referring to FIG. 4 and FIG. 6). In such cases, the width of the capillary through holes 250 should not be too large to block capillary flow. The width of the capillary through holes 250 is controlled below hundreds of microns, such as 1 micron, 10 microns, 50 microns, 100 microns and 200 microns. When the size of the capillary through holes 250 is small, the capillary through holes 250 can be formed only at bottoms of the first diversion grooves (the capillary through holes do not span multiple first diversion grooves), referring to FIG. 3 and FIG. 5. The capillary through holes 250 in FIG. 4 and FIG. 6 are in a strip shape. The included angle $\alpha$ between the longitudinal direction of the capillary through holes 250 and the direction of the first diversion grooves can be either acute (referring to FIG. 4) or right (referring to FIG. 6). The capillary through holes 250 in FIG. 3 are in a circular or elliptical shape. The capillary through holes 250 in FIG. 5 are in a rectangular shape.

The formation of the capillary through holes 250 can be achieved by laser machining, chemical etching methods, ion etching methods (RIE, DRIE), electrochemical methods or mechanical machining methods, etc. As an example, the capillary through holes 250 can be in a circular shape, an elliptical shape, an arc shape, a triangular shape, a square shape, a trapezoidal shape, a star shape, a strip shape or a combination thereof. The minimum size of the capillary through holes 250 is determined by the required capillary pressure, which can vary from several nanometers to several millimeters.

As a possible example, referring to FIG. 1, and FIG. 3 to FIG. 6, second diversion grooves 220 are further formed in the wick 200, and the second diversion grooves 220 are located on a side, adjacent to the vapor chamber 103, of the wick 200. The second diversion grooves 220 are configured for connecting the heat source area 400 with the heat dissipation area 420, so that the working liquid 300 condensed in the heat dissipation area 420 can flow back to the heat source area 400 through the second diversion grooves 220 under capillary pressure. Compared with the first capillary channels 210, the second diversion grooves 220 are not of a complete tubular structure, so the capillary pressure is relatively small, and the second diversion grooves 220 are used as auxiliary channels for the working liquid 300. Referring to FIG. 14, the first diversion grooves 210 and the second diversion grooves 220 can be designed in different widths along a flow direction of the working liquid 300 according to the shape of the temperature equalization board to adjust the vapor-liquid contact surface and the capillary force.

According to different heat dissipation requirements, the sizes and spacings of the first diversion grooves and the second diversion grooves 220 of different wicks 200 can be adjusted, and the sizes and spacings of the first diversion grooves 210 and the second diversion grooves 220 can also be adjusted at different positions of the same wick 200. The width W1, the spacing W2 and the height H1 of the capillary channels of the wick 200 as shown in FIG. 17 and FIG. 18 can vary from several nanometers to thousands of microns, such as 10 nanometers, 100 nanometers, 1 micron, 10 microns, 50 microns, 100 microns, 200 microns, 500 microns and 1000 microns.

As a possible example, referring to FIG. 2, and FIG. 8 to FIG. 10, connecting channels 230 are further formed in the wick 200. A plurality of first capillary channels 210 are provided. Every two adjacent first capillary channels 210 are connected through the connecting channels 230, so that the working liquid 300 and vapor of the working liquid 300 can flow between different first capillary channels 210. A mesh structure can be formed by connecting the adjacent first capillary channels 210 through the connecting channels 230, so that the balanced distribution and rapid flow of the working liquid 300 can be facilitated.

As a possible example, referring to FIG. 2, the connecting channels 230 include connecting grooves, and the connecting grooves are configured for forming second capillary channels together with the cover plates. It can be understood that connecting holes can also be formed in the connecting channels 230. In the example, the second capillary channels are in a rectangular shape. The size of the second capillary channels can be selected according to the width W1 and the height H1 of the capillary channels, and varies from several nanometers to several thousands of microns, such as 10 nanometers, 100 nanometers, 1 micron, 10 microns, 50 microns, 100 microns, 200 microns, 500 microns and 1000 microns.

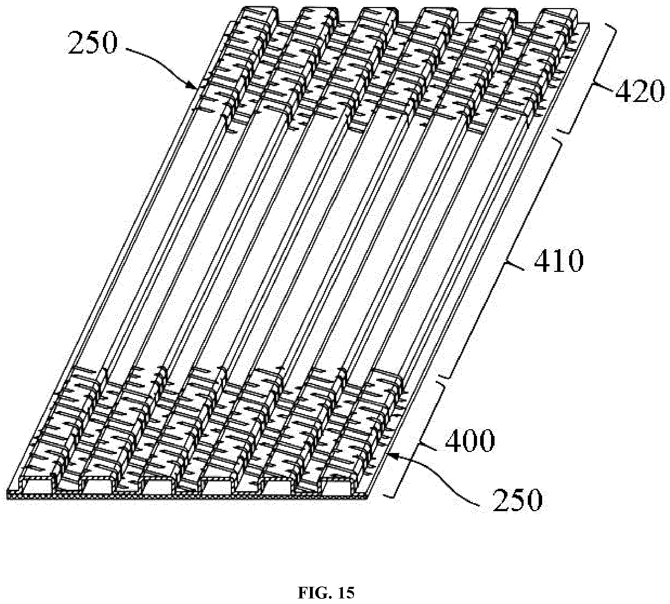

As a possible example, referring to FIG. 15, the wick 200 covers the heat source area 400, the adiabatic area 410 and the heat dissipation area 420. The capillary through holes 250 are formed in the heat source area 400 and the heat dissipation area 420 of the wick 200, and the capillary through holes 250 can be in the previously described shape or a combination thereof. Through the first capillary channels 210 corresponding to the wick 200 and the second diversion grooves 220 of the wick 200, the working liquid 300 condensed in the heat dissipation area 420 flows back to the heat source area 400 under capillary pressure.

As a possible example, referring to FIG. 16, where the adiabatic area 410 is absent in the temperature equalization board, the wick 200 covers the whole area. The capillary through holes 250 are formed throughout the whole area of the wick 200, and the capillary through holes 250 can be in a circular shape, an elliptical shape, an arc shape, a triangular shape, a square shape, a trapezoidal shape, a star shape, a strip shape or a combination thereof. Through the first capillary channels 210 corresponding to the wick 200 and the second diversion grooves 220 of the wick 200, the working liquid 300 condensed in the heat dissipation area 420 directly flows back to the heat source area 400 under capillary pressure.

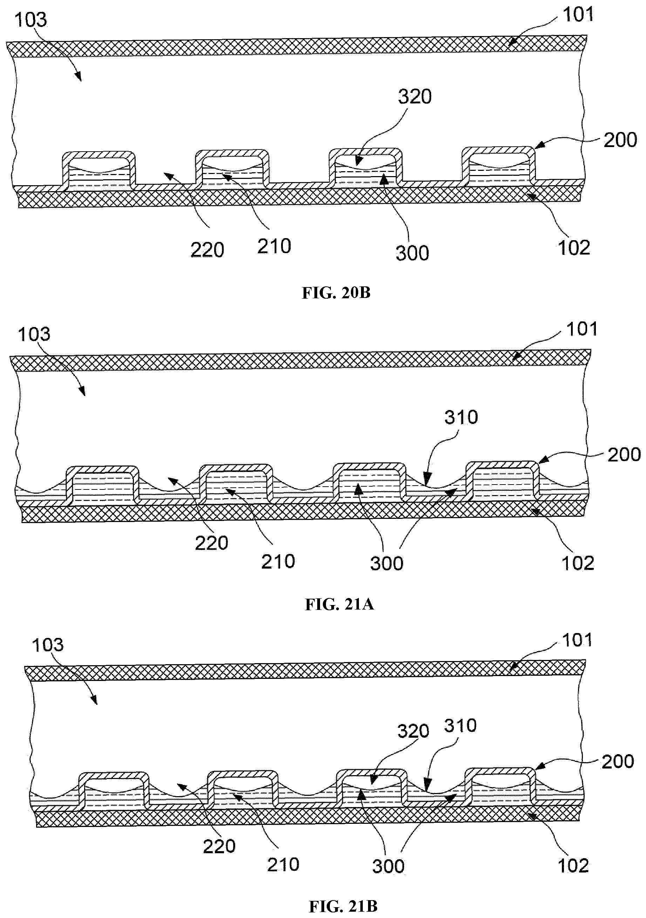

The first capillary channels 210 may be fully filled with the working liquid 300 (see FIG. 20A) when no vapor is enters. When the vapor enters, the first capillary channels 210 are partially filled with the working liquid 300 (see FIG. 20B).

For the above example (example A for short) in which all the first diversion grooves, the second diversion grooves 220, and the capillary through holes 250 are formed in the wick 200:
In the heat source area 400 and the heat dissipation area 420, the working liquid 300 in the first capillary channels 210 enters the second diversion grooves 220 (see FIG. 21A). The working liquid 300 is transported by both the first capillary channels 210 and the second diversion grooves 220, and second vapor-liquid interfaces 310 are formed in the second diversion grooves 220. FIG. 21B illustrates the flow condition that the first capillary channels 210 are partially filled with the working liquid 300 when vapor enters some parts, and the vapor-liquid interfaces are formed in both the first capillary channels 210 and the second diversion grooves 220.

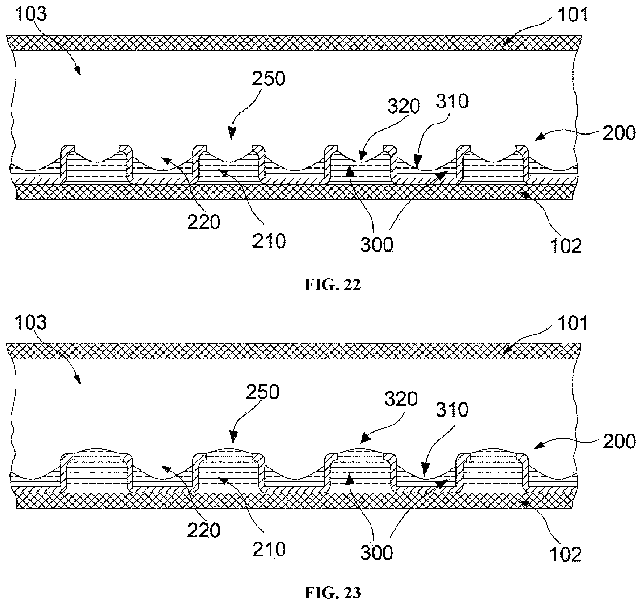

For the wick 200 at the heat source area 400 (see FIG. 22), capillary through holes 250 are formed in the first capillary channels 210. The first capillary channels 210 and the second diversion grooves 220 are both filled with the working liquid 300. First vapor-liquid interfaces 320 are formed in the first capillary channels 210, and second vapor-liquid interfaces 310 are formed in the second diversion grooves 220. The vapor-liquid interfaces provide capillary pressures.

For the wick 200 (see FIG. 23) at the heat dissipation area 420, capillary through holes 250 are formed in the first capillary channels 210. The first capillary channel 210 and the second diversion grooves 220 are both filled with the working liquid 300. First vapor-liquid interfaces 320 are formed in the first capillary channels 210, and second vapor-liquid interface 310 are formed in the second diversion grooves 220. Capillary pressures are generated at the vapor-liquid interfaces.

Different capillary pressures are generated at the second vapor-liquid interfaces 310 of the second diversion grooves 220 in the heat source area 400 and the heat dissipation area 420 due to the evaporation and condensation processes, as well as the adjustment of the size of the capillary through holes 250. Finally a capillary pressure difference is achieved between the heat source area 400 and the heat dissipation area 420.

For the above example A, the working principle of the wick is as follows.

In the example A, the first key point of the working principle of the wick 200 is to increase the pressure difference through the arrangement and adjustment of size of the capillary through holes 250. The capillary through holes 250 (FIG. 22 and FIG. 23) are formed in the first capillary channels 210, and the first capillary channels 210 are connected with the vapor chamber 103 through the first vapor-liquid interfaces 320, so that the working liquid 300 and vapor of the working liquid 300 flow between the first capillary channels 210 and the vapor chamber 103. Different capillary pressures are produced at the second vapor-liquid interfaces 320 in the heat source area 400 and the heat dissipation area 420 by forming different vapor-liquid interface curvature radii due to the evaporation and condensation processes, as well as the adjustment of the size of the capillary through holes 250, and finally a capillary pressure difference is formed between the heat source area 400 and the heat dissipation area 420 to drive the working liquid 300 to flow back to the heat source area 400 from the heat dissipation area 420.

In the example A, the second diversion grooves 220 serve as auxiliary channels for transporting the working liquid 300. In the heat source area 400, besides the first vapor-liquid interfaces 320 serving as the evaporation interfaces, the second vapor-liquid interfaces 310 also serve as the evaporation interfaces. In the heat dissipation area 420, besides the first vapor-liquid interface 320 serving as the condensation interface, the second vapor-liquid interfaces 310 also serve as the condensation interface. Different capillary pressures are produced at the second vapor-liquid interfaces 310 of the second diversion grooves 220 in the heat source area 400 and the heat dissipation area 420 due to the evaporation and condensation processes, as well as the adjustment of the size of the capillary through holes 250, and finally a capillary pressure difference is formed between both ends of the second diversion grooves 220 to drive the working liquid 300 to flow back from the second diversion grooves 220. Compared with the first capillary channels 210, the second diversion grooves 220 are not of a complete tubular structure, so the capillary pressure is relatively smaller.

As a preferred example, first ends of the first capillary channels 210 are configured for being located in the heat source area 400, and second ends of the first capillary channels 210 are configured for being located in the heat dissipation area 420. The effective capillary radius of the capillary through holes 250 at the first ends of the first capillary channels 210 is smaller than that of the capillary through holes 250 at the second ends of the first capillary channels 210 so as to increase the capillary pressure for the working liquid to flow back to the heat source area. In order to facilitate understanding, the principle is explained as follows.

For a capillary channel with a length of *L,* a hydraulic radius of R and a cross-sectional area of *A,* the flow rate *Q* is described by the following equation:

$$Q = \frac{aR^2 A \Delta P}{\mu L}, \qquad\qquad (1)$$

Wherein, *a* is a dimensionless coefficient related to the cross-sectional shape of the capillary channel, $\mu$ is viscosity of the fluid, and $\Delta P$ is the pressure difference between two ends of the capillary channel.

For a circular cross-section channel with a radius of *R*,

$$Q = \frac{\pi R^4 \Delta P}{8\mu L};$$

For a rectangular cross-section channel with a bottom width of *w* and a height of *h* = *βw*,

$$Q = (1 - \frac{2\beta}{\pi}\tanh\frac{\pi}{2\beta})\frac{8h^3 w\Delta P}{\pi^4 \mu L}.$$

According to the equation (1), the capillary flow rate can be increased by increasing the cross-sectional size of the capillary channel and the pressure difference between the two ends of the capillary channel. In the case of ignoring the influence of gravity,

$$\Delta P = \Delta P_{ce} - \Delta P_{cc}, \qquad (2)$$

Wherein, $\Delta P_{ce}$ is a capillary pressure produced by the capillary through holes 250 at an evaporation end (corresponding to the first ends of the first capillary channels 210 in the example A), and $\Delta P_{cc}$ is a capillary pressure produced by the capillary through holes 250 at a condensation end (corresponding to the second ends of the first capillary channels 210 in the example A), which can be expressed by the effective capillary radius $r_e$ of the capillary through holes 250 at the evaporation end and the effective capillary radius $r_c$ of the capillary through holes 250 at the condensation end.

$$\Delta P_{ce} = \frac{2\sigma\cos\theta_e}{r_e}, \qquad (3)$$

$$\Delta P_{cc} = \frac{2\sigma\cos\theta_c}{r_c}. \qquad (4)$$

Wherein, $\sigma$ is a surface tension coefficient, $\theta_e$ and $\theta_c$ are contact angles at the evaporation end and the condensation end, respectively. The equations (3) and (4) are substituted into equation (2), and the pressure difference between both ends of the capillary channel can be written as:

$$\Delta P = 2\sigma(\frac{\cos\theta_e}{r_e} - \frac{\cos\theta_c}{r_c}). \qquad (5)$$

According to the equation (5), for given contact angles, the pressure difference can be increased by adjusting the effective radius of the capillary through holes 250, for example, reducing the effective radius of the capillary through holes 250, making $r_e < r_c$, or a combination thereof.

The second core of the working principle in the example A is the adjustment of the size of the first capillary channels 210. Under certain capillary pressure, the cross-sectional size of the first capillary channels 210 determines the flow rate of the capillary channel, when the cross-sectional size is increased, the flow rate can be increased. This solves the problems that small-diameter capillary tubes or capillary grooves of traditional capillary materials are high in capillary pressure, but large in flow resistance and small in flow rate. Compared with the prior art, in the example A, during the process that the working liquid 300 flows back to the heat source area 400 from the heat dissipation area 420 along the first capillary channels 210 and the second diversion grooves 220, the capillary pressure is higher, the flow resistance of the working liquid 300 is smaller, the backflow velocity of the working liquid 300 to the heat source area 400 can be effectively increased, and thus the heat transfer capability is improved.

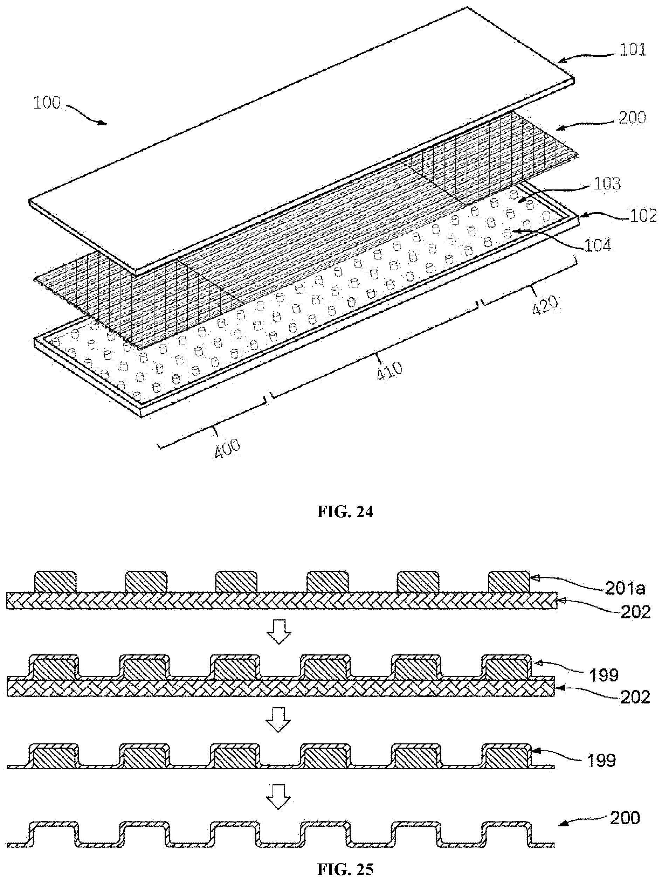

Referring to FIG. 24, the embodiment also provides a temperature equalization board 100. The temperature equalization board 100 includes a wick 200 and a housing. The wick 200 is the above wick 200 which includes the first diversion grooves. The housing includes cover plates. Sides of the cover plates are configured for being in contact with a heat source, and another sides of the cover plates are configured for forming first capillary channels 210 together with the first diversion grooves.

The temperature equalization board 100 in the embodiment includes the wick 200, so that the temperature equalization board 100 also has the advantages of the wick 200, which will not be repeated here.

As a possible example, referring to FIG. 24, the housing includes a vapor chamber 103, and the vapor chamber 103 is located on a side, away from the cover plates, of the wick 200. Through holes for communicating the first diversion grooves and the vapor chamber 103 are formed in the wick 200 for the working liquid 300 and vapor of the working liquid 300 to flow between the first diversion grooves and the vapor chamber 103.

Referring to FIG. 24, the housing generally includes a second cover plate 102 and a second cover plate 101. The second cover plate 102 and the second cover plate 101 are connected through several side plates. The wick 200 is located between the second cover plate 102 and the second cover plate 101. The wick 200 is fixed on the second cover plate 102, and the vapor chamber 103 is located between the wick 200 and the second cover plate 101. For clarity, the side plates of the housing are omitted in FIG. 24, and only the cover plates of the housing are shown.

As a possible example, referring to FIG. 24, the temperature equalization board 100 also includes supports 104. Supports 104 are (completely or partially) located in the vapor chamber 103 to limit the minimum height of the vapor chamber 103. When the supports 104 are completely located in the vapor chamber 103, upper ends of the supports 104 abut against the wick 200, and lower ends of the supports 104 abut against the lower cover plate. When the supports 104 are partially located in the vapor chamber 103, the supports 104 pass through the wick 200, and both ends of the supports 104 abut against the two cover plates, respectively. By arranging the supports 104, collapse of the vapor chamber 103 can be prevented.

The embodiment also provides a preparation method of a wick 200, for preparing the above wick 200, referring to FIG. 25, FIG. 26 and FIG. 27, including the following steps.

S1, mold preparation.

Strip structures 201a are arranged on a surface of a base 202 to obtain a mold substrate.

The base 202 can be made of inorganic materials (such as copper, aluminum, nickel, zinc, tin, gold, iron, cobalt, cadmium, chromium, tin, silver, titanium, palladium, or stainless steel, zinc-nickel, zinc-copper, zinc-iron, nickel-iron, nickel-cobalt, copper-tin, zinc-nickel-iron, tin-zinc-antimony, zinc-tin-iron, tin-zinc-cobalt, and other alloys) or organic materials (such as ABS acrylonitrile-butadiene-styrene, EVA ethylene-vinyl acetate copolymer, EPS polystyrene, HDPE high density polyethylene, LDPE low density polyethylene, PI polyimide, PET polyester, PE polyethylene, PP polypropylene, PC polycarbonate, PVC polyvinyl chloride, PU polyurethane, PMMA polymethyl methacrylate, PS polystyrene, PDMS polydimethylsiloxane, PPS polyphenylene sulfide, Teflon, Nylon and PEEK polyether-ether-ketone) or mixed materials (such as a mixture of organic materials, a mixture of inorganic materials or a mixture of organic and inorganic materials).

The strip structures 201a can be prepared through photolithography (such as soft lithography and laser etching), printing (including 2D and 3D printing, wax printing, screen printing), spraying (including cold spraying and hot spraying), etching and machining, etc. Soft lithography is a commonly used micro-nano processing method, which will not be described in detail herein. For the printing method, firstly, the printing materials needs to be prepared, and then the materials are printed onto the substrate through the printing method so that the mold substrate is obtained. Depending on the technologies, main ingredients of the printing materials can be materials based on photosensitive materials or materials based on metal particles. Depending on the preparation methods of the capillary channels, the surface of the mold substrate needs to be pre-treated sometimes. For example, the surface of the mold substrate needs to be conductive.

S2, preparation of capillary channels.

A metal layer 199 is deposited on the substrate, and the strip structures 201a and at least part of the surface where the strip structures 201a are located are covered with the metal layer 199. The material of the metal layer 199 is different from the materials of the strip structures 201a and the substrate 202. The base 202 and the strip structures 201a are removed to obtain an independent wick 200. The wick 200 includes first diversion grooves, and the first diversion grooves are formed after the strip structures 201a are removed.

The metal layer 199 is preferably made of copper, aluminum, nickel, zinc, tin, gold, iron, cobalt, cadmium, chromium, tin, silver, titanium, palladium, or stainless steel, zinc-nickel, zinc-copper, zinc-iron, nickel-iron, nickel-cobalt, copper-tin, zinc-nickel-iron, tin-zinc-antimony, zinc-tin-iron, tin-zinc-cobalt, and other alloys.

S3, preparation of capillary through holes 250.

Capillary through holes 250 are formed in the wick 200. The formation of the capillary through holes 250 can be performed by laser machining, chemical etching methods, etching methods (e.g., ICP or Inductively Coupled Plasma etching, RIE, DRIE), electrochemical methods or mechanical machining methods, etc. The capillary through holes 250 can be of a circular shape, an elliptical shape, an arc shape, a triangular shape, a square shape, a trapezoidal shape, a star shape, a strip shape or a combination thereof.

As a possible example, the material of the strip structures 201a can be the same or different from the material of the base 202. The materials of the strip structures 201a and the base 202 can be removed by etching or hot melt (for example, the materials are polymer materials such as PC polycarbonate, PU polyurethane and PDMS polydimethylsiloxane) or etching and peeling (for example, the materials are mixed materials, such as a mixture of metal and polymer materials or a mixture of salt and polymer materials) and other methods. The metal layer 199 is preferably made of copper, aluminum, nickel, zinc and tin, etc. and the deposition method can be PVD (Physical Vapor Deposition), electroplating, etc.

As a possible example, the thickness of the metal layer can be determined according to the size of the temperature equalization board, which can vary from several nanometers to several millimeters, but the thickness is controlled between 1 micron and 50 microns for general applications.

As a possible example, the size (such as radius or length and width) of the capillary through holes 250 can be determined according to the heat dissipation requirements of the temperature equalization board, the velocity requirements of the capillary circulation of the working liquid, and the working conditions (such as the influence of gravity or other accelerations). This size can vary from several nanometers to several millimeters, but the size is controlled between several microns and several hundred microns for general applications.

The preparation method of a wick 200 is described below with reference to examples 1 to 3.

Referring to FIG. 25, in the example 1, (S1) mold preparation: strip structures 201a are formed on a base 202 through photolithography. The cross section of the strip structures 201a can be in a rectangular shape, a trapezoidal shape, a semi arc shape, or similar shapes. (S2) Deposition of metal layer: necessary surface pretreatment is performed on the base, then a metal layer 199 is deposited on the base, the base 202 and the strip structures 201a are removed, and finally an independent wick 200 is obtained. (S3) Formation of capillary through holes 250: capillary through holes 250 are formed in the wick 200 to obtain a porous wick 200. The formation of the capillary through holes 250 can be achieved by laser machining, chemical etching methods, etching methods (e.g., ICP or Inductively Coupled Plasma etching, RIE, DRIE), electrochemical methods or mechanical machining methods, etc. The capillary through hole 250 can be in a circular shape, an elliptical shape, an arc shape, a triangular shape, a square shape, a trapezoidal shape, a star shape, a strip shape or a combination thereof.

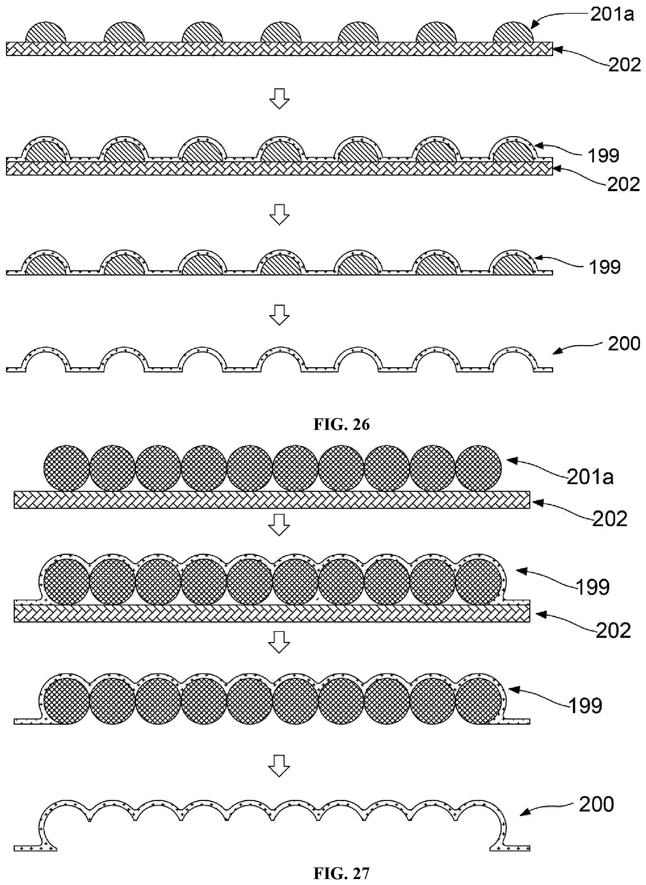

Referring to FIG. 26, in the example 2, strip structures 201a are formed on the base 202 by printing to obtain a substrate. The cross section of the strip structures 201a can be in a semi-circular shape, a superior arc bow shape or an inferior arc bow shape. A metal layer 199 is deposited on the base, then the base 202 and the strip structures 201a are removed, and finally a wick 200 is obtained. Finally, the capillary through holes 250 are formed in the wick 200 through laser method, and a porous wick 200 is obtained.

Referring to FIG. 27, in the example 3, wires 201a are arranged on the base 202 to obtain a mold substrate. A metal layer 199 is deposited on the base, then the base 202 and the strip structures 201a are removed, and a wick 200 is obtained. Finally, capillary through holes 250 are formed in the wick 200 through laser method, and finally a porous wick 200 is obtained. The material of the wires is the same as the material of the strip structures 201a described above.

For the wick 200 prepared according to the above method, the capillary pressure is higher when transporting the working liquid, and the flow resistance of the working liquid is smaller, so that it is more effective. In order to verify the progressiveness of the wick 200, a wick 200 is prepared for comparison with a commonly used copper wire mesh material. The lengths of the two are both 75 mm. The copper wire mesh material has a mesh number of 300, the diameter of the copper wire is 30 microns and the total thickness of the copper wire mesh material is 60 microns. The wick 200 prepared according to the preparation method in the embodiment has a total thickness of 51 microns, the depth of the first diversion groove is 36 microns. The capillary through holes 250 are formed in the wick 200 at both the evaporation end and the condensation end, the width of the capillary through holes 250 is 100 microns, and the length-width ratio is 1:10 (namely, the effective capillary radii of the capillary through holes 250 at both ends of the first diversion groove are the same). For an area with through holes, both the condensation end and the evaporation end are 25 mm in length. Both the wick 200 and the copper wire mesh material are sintered on copper sheets (mimicking the cover plates) through the same heat treatment process to obtain a sintered structure (see FIG. 15 for the sintered structure of the wick 200 and the cover plate). The first capillary channels 210 and the second diversion grooves 220 are formed by the wick 200 and the copper sheet, and the capillary through holes 250 are formed in both ends of the first capillary channel 210 by laser processing. After cleaning, drying and reduction of two sintered structures, ends of the sintered structures are inserted into deionized water, and the climbing process of water in material is photographed by a camera. Then, the water surface position at each time point is measured by an image analysis method.

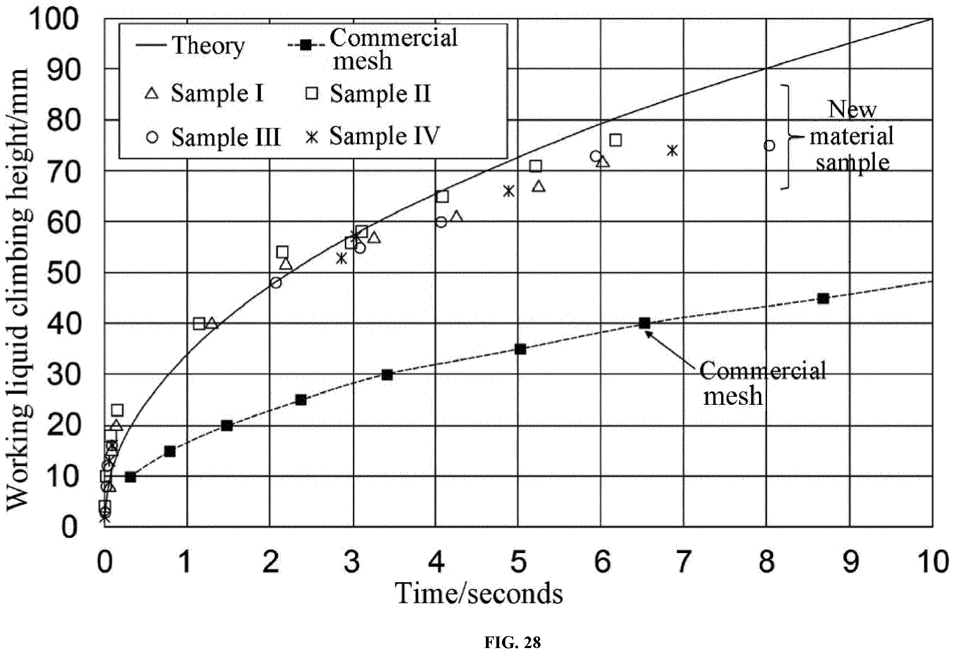

FIG. 28 illustrates a theoretical time curve of water climbing of the wick 200, a time curve of water climbing of the copper wire mesh material, and actual water climbing process of four wicks 200 prepared according to the preparation method in the embodiment. The climbing curves of the sintered structures of the four wicks 200 prepared according to the preparation method in the embodiment are very similar, and the consistency of the material preparation process is shown. And the climbing speed and the climbing height are both significantly superior to those of the sintered structure of the copper wire mesh material. At the initial stage of climbing, the climbing speed of the wick 200 is three to four times of that of the copper wire mesh material, and the final climbing height of the wick 200 is almost twice of that of the copper wire mesh material, so that the capillary diversion effect of the wick 200 on the working liquid is stronger.

Specific examples are used for illustration of the principles and implementations of the present invention. The description of the above-mentioned embodiments is used to help illustrate the method and its core principles of the present invention. In addition, those skilled in the art can make various modifications to the specific embodiments and scope of application in accordance with the teachings of the present invention. In summary, the contents of this specification should not be understood as the limitation of the present invention.

**Claims**

1. A wick installed inside a housing comprising cover plates, first diversion grooves are formed in the wick; the first diversion grooves are configured for forming first capillary channels together with the cover plates; the first capillary channels are configured for connecting a heat source area and a heat dissipation area, so that working liquid condensed in the heat dissipation area is capable of flowing back to the heat source area through the first capillary channels under capillary pressure.

2. The wick according to claim 1, wherein the housing comprises a vapor chamber, and the vapor chamber is located on a side, away from the cover plates, of the wick; capillary through holes are formed in the wick, and the capillary through holes are configured for communicating the first diversion grooves with the vapor chamber, so that the working liquid and vapor of the working liquid are capable of flowing between the first diversion grooves and the vapor chamber.

3. The wick according to claim 2, wherein second diversion grooves are further formed in the wick, and the second diversion grooves are located on a side, adjacent to the vapor chamber, of the wick; the second diversion grooves are configured for connecting the heat source area with the heat dissipation area, so that the working liquid condensed in the heat dissipation area is capable of flowing back to the heat source area through the second capillary channels under capillary pressure.

4. The wick according to claim 3, wherein first ends of the first capillary channels are configured for being located in the heat source area, and second ends of the first capillary channels are configured for being located in the heat dissipation area; an effective capillary radius of the capillary through holes located at the first ends of the first capillary channels is smaller than that of the capillary through holes located at the second ends of the first capillary channels so as to increase the capillary pressure for the working liquid to flow back to the heat source area.

5. The wick according to claim 1, wherein connecting channels are further formed in the wick; a plurality of first capillary channels are provided, and every two adjacent first capillary channels are connected through the connecting channels, so that the working liquid and vapor of the working liquid are capable of flowing between different first capillary channels.

6. The wick according to claim 5, wherein the connecting channels comprise connecting grooves, and the connecting grooves are configured for forming second capillary channels together with the cover plates.

7. A temperature equalization board, comprising the wick according to claim 1, 5 or 6, and a housing, wherein the housing comprises the cover plates, sides of the cover plates are configured for being in contact with a heat source, and another sides of the cover plates are configured for forming the first capillary channels together with the first diversion grooves.

8. The temperature equalization board according to claim 7, wherein the housing comprises a vapor chamber, and the vapor chamber is located on a side, away from the cover plates, of the wick; capillary through holes are formed in the wick, and the capillary through holes are configured for communicating the first diversion grooves with the vapor chamber, so that the working liquid and vapor of the working liquid are capable of flowing between the first diversion grooves and the vapor chamber.

9. A preparation method of a wick, for preparing the wick according to claim 1, comprising the flowing steps:

    S1, arranging strip structures on a surface of a base to obtain a substrate, providing the surface, with the strip structures, of the substrate as a deposition surface;
    S2, depositing a metal layer on the deposition surface of the substrate to cover at least part of a deposited surface; the metal layer is made of material different from materials of both the strip structures and the base; and
    S3, removing the base and the strip structures for forming the first diversion grooves.

10. The preparation method of the wick according to claim 9, further comprising:
    S4, forming capillary through holes in the first diversion grooves.

**FIG. 1**

**FIG. 2**

**FIG. 3**

**FIG. 4**

FIG. 5

FIG. 6

210

400

**FIG. 7**

**FIG. 8**

210

400

**FIG. 9**

**FIG. 10**

400

**FIG. 11**

210

400

**FIG. 12**

**FIG. 13**

**FIG. 14**

**FIG. 15**

**FIG. 16**

**FIG. 17**

FIG. 18

FIG. 19

FIG. 20A

**FIG. 20B**

**FIG. 21A**

**FIG. 21B**

103          101

250

320   310

200

220   210   300   102

**FIG. 22**

103          101

250

320   310

200

220   210   300   102

**FIG. 23**

**FIG. 24**

**FIG. 25**

**FIG. 26**

**FIG. 27**

FIG. 28

EP 4 582 761 A1

## INTERNATIONAL SEARCH REPORT

| International application No. |
|---|
| **PCT/CN2023/128021** |

| A. | CLASSIFICATION OF SUBJECT MATTER |
|---|---|

F28D15/04(2006.01)i

According to International Patent Classification (IPC) or to both national classification and IPC

| B. | FIELDS SEARCHED |
|---|---|

Minimum documentation searched (classification system followed by classification symbols)

IPC:F28D15, H05K7

Documentation searched other than minimum documentation to the extent that such documents are included in the fields searched

Electronic data base consulted during the international search (name of data base and, where practicable, search terms used)

CNTXT, ENTXTC, VEN, CNKI: 槽, 箔片, 薄片, 孔, 缝, 平衡, 均衡, groove, slot, foil, paillon, sheet, leaf

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 101131308 A (FOSHAN SHUNDE SHUNDA COMPUTER FACTORY CO., LTD. et al.) 27 February 2008 (2008-02-27) description, page 5, line 30 to page 8, line 21, and figures 1-10 | 1-3, 7-10 |
| Y | CN 101131308 A (FOSHAN SHUNDE SHUNDA COMPUTER FACTORY CO., LTD. et al.) 27 February 2008 (2008-02-27) description, page 5, line 30 to page 8, line 21, and figures 1-10 | 4-6 |
| Y | CN 101059322 A (FUZHUN PRECISION INDUSTRY (SHENZHEN) CO., LTD. et al.) 24 October 2007 (2007-10-24) description, page 3, line 1 to page 4, line 24, and figures 1-5 | 4 |
| Y | CN 113316355 A (JIANGXI ZHANYAO MICROELECTRONICS CO., LTD.) 27 August 2021 (2021-08-27) description, paragraphs [0035]-[0076], and figures 1-8 | 5-6 |
| A | CN 105674780 A (INSTITUTE OF ENGINEERING THERMOPHYSICS, CHINESE ACADEMY OF SCIENCES et al.) 15 June 2016 (2016-06-15) entire document | 1-10 |

☑ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **03 July 2024** | **13 July 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

<table>
<tr><td colspan="2">International application No.</td></tr>
<tr><td colspan="2">**PCT/CN2023/128021**</td></tr>
</table>

**C.    DOCUMENTS CONSIDERED TO BE RELEVANT**

| Category* | Citation of document, with indication, where appropriate, of the relevant passages | Relevant to claim No. |
|---|---|---|
| A | CN 105865241 A (GUANGZHOU HUAZUAN ELECTRONIC TECHNOLOGY CO., LTD.) 17 August 2016 (2016-08-17) <br> entire document | 1-10 |
| A | KR 20040015887 A (LG CABLE LTD.) 21 February 2004 (2004-02-21) <br> entire document | 1-10 |
| A | WO 2021213391 A1 (HUAWEI TECHNOLOGIES CO., LTD.) 28 October 2021 (2021-10-28) <br> entire document | 1-10 |
| A | US 2021385973 A1 (ABB SCHWEIZ AG et al.) 09 December 2021 (2021-12-09) <br> entire document | 1-10 |
| A | US 2007235165 A1 (FOXCONN TECHNOLOGY CO., LTD.) 11 October 2007 (2007-10-11) <br> entire document | 1-10 |

Form PCT/ISA/210 (second sheet) (July 2022)

**INTERNATIONAL SEARCH REPORT**
Information on patent family members

International application No.

**PCT/CN2023/128021**

| Patent document cited in search report | | | Publication date (day/month/year) | Patent family member(s) | | | Publication date (day/month/year) |
|---|---|---|---|---|---|---|---|
| CN | 101131308 | A | 27 February 2008 | None | | | |
| CN | 101059322 | A | 24 October 2007 | US | 2007246194 | A1 | 25 October 2007 |
| CN | 113316355 | A | 27 August 2021 | None | | | |
| CN | 105674780 | A | 15 June 2016 | None | | | |
| CN | 105865241 | A | 17 August 2016 | None | | | |
| KR | 20040015887 | A | 21 February 2004 | KR | 100436589 | B1 | 19 June 2004 |
| WO | 2021213391 | A1 | 28 October 2021 | None | | | |
| US | 2021385973 | A1 | 09 December 2021 | EP | 3919850 | A1 | 08 December 2021 |
| US | 2007235165 | A1 | 11 October 2007 | None | | | |

Form PCT/ISA/210 (patent family annex) (July 2022)